# EUROPEAN PATENT APPLICATION

(11) **EP 1 479 710 A1**
(43) Date of publication of application: **24.11.2004**
(21) Application number: 04007069.0
(22) Date of filing: 24.03.2004
(51) Int. Cl.: C08G 63/91, C08G 69/44, C08G 77/445, C08L 77/12, C08L 83/10, C08G 77/455, C08G 77/388

(54) **Production of polymer compounds between polyester and diamine, a polymer compound and a structure including thereof**

(30) Priority: 28.03.2003 JP 2003091919; 22.05.2003 JP 2003144385
(71) Applicant: M & S Research and Development Co., Ltd., Tsu-shi, Mie, 514-0063 (JP)
(72) Inventor: Nakano, Seiko, Tsu-Shi Mie, 514-0063 (JP)
(74) Representative: Manitz, Finsterwald & Partner GbR

(57) **Abstract**

A novel method for producing polyamide and/or polyester-amide copolymer is provided. The method of the present invention comprises the steps of: providing particles of the polyester, the polyester having pores extending from a surface of the particle to inside thereof; mixing the porous polyester with the diamine; and heating the mixture to the temperature not lower than a melting point of the diamine and not higher than a significant temperature of the polyester to cause reaction between the polyester and the diamine.

## Description

### Field of Invention

The present invention relates to a method for producing polyamide and/or polyester-amide copolymer by using polyester and diamine as raw materials, the polymer compound produced by the above method, and a structure including the polymer compound, and particularly relates to a method for advantageously producing polyamide and/or polyester-amide copolymer using porous polyester, the polymer compound produced by the above method, and a structure including the polymer compound suitably used for the electronics field.

### Background Art

A method for producing high molecular weight polyamide and/or polyester-amide copolymer by reacting polyester and diamine under a solvent less condition is disclosed in Japanese Patent (Laid-Open) No. 2000-11175. The disclosed method uses no solvent at all during the production processes, and hence the disclosed method is desirable, when compared to methods which use solvents, with respect to the points of large decrease in production costs and earth environment. However, the above solvent less method creates the problem in which parts of reaction products aggregate during the reaction process to form chunks and more severely, the production process would go to fail because the reaction products form a huge lump in a reaction vessel under the condition where large amounts of diamine especially having high viscosity diamino-polymer are used.

In turn, recently, high density implementation on an electric circuit becomes more and more necessary as electronics machines become smaller and thinner as well as lighter. Therefore, insulator materials for a print circuit board is desired to have high thermal durability (high Tg: glass transition temperature), a low dielectric constant, and a low dielectric loss tangent value. It is thought more recently for an ideal insulator material of the print circuit board to provide with halogen free fire-retardant property and recycling-ability from the point of environment safety. Though cross-linked epoxy has been conventionally widely used as insulator material for the print circuit board, recently, polyimide has popularly used with respect to the thermal durability thereof. However, polyimide can not be ideal material as electric insulator material because of its large dielectric constant and its moisture absorbency. Also, the polyimide requires thermal pressurization at above 200 Celsius degrees in order to provide sufficient adhesion strength to base materials. This condition is not preferred when one considers oxidation of the circuit. Cross-linked polyphenylene oxide and BT resin and the like are studied; however, these materials have defects while providing advantages. Thus, the ideal material having high thermal durability, a low dielectric constant, a low dielectric loss tangent value, a halogen less fire-retardant property as well as excellent recycle-ability has not been proposed so far.

A trial for developing new electric insulator material having excellent electric properties (a low dielectric constant and a low dielectric loss tangent value) while having water repellency and a fire-retardant property has disclosed. Siloxane structures were introduced to polyimide or aramide in Japanese Patent (Laid-Open) Heisei No. 8-193139 or Japanese Patent (Laid-Open) Heisei No. 7-292342, respectively, for trying to develop insulation material for print circuit boards etc. In Japanese Patent (Laid-Open) Shouwa No. 60-141723 or Japanese Patent (Laid-Open) Heisei No. 9-151255, the development of the insulation material for the print circuit board were disclosed by introducing poly-siloxane structures into polyalylate in order to improve workability and/or mold-ability and anti-abrasion properties of the polyalylate. Thus, it is known in the art to introduce polyorganosiloxane structures into various materials having high thermal durability. However, there are many problems in the above conventional attempts for introducing polyorganosiloxane structures therein because such attempts depend on already present synthesis technologies; that is to say, components including siloxane structures generally have less phase solubility with other reaction substances such as monomers or reaction media (solvents) so that the target material including high siloxane contents can not be precisely obtained in high yield thereby resulting in suffering in difficulties that insulation material having objected material properties can not be derived.

The inventor now proposes a novel production method for producing polyester-amide copolymer in which porous polyester is caused to react to polyorganosiloxane to form polyester-siloxane structure by using an ester-amide exchange reaction.

### Disclosure of Invention

The inventor has completed the invention by continuous studies for the production method without problems in which the reaction products create chunks and the lump even when large amounts of diamine compounds especially including high viscosity diamino-polymer compounds under a solvent less condition are used.

Therefore, an object of the present invention is to provide a novel production method of polyamide and/or polyester-amide copolymer without providing the above problems while maintaining advantages of the solvent less process.

Further another object of the present invention is to provide a novel polymer compound including novel morphology.

Further another object of the present invention is to provide a structure including the novel polymer suitably used for electronic parts.

According to the present invention, a method for producing polymer compound by reacting polyester polymerized from a dicarboxylic acid and a component of two OH functional groups and having intrinsic viscosity not less than 0.2 dl/g with a diamine is provided. The method comprises the steps of:
providing particles of the polyester, the polyester having pores extending from a surface of the particle to inside thereof;
mixing the porous polyester with the diamine; and
heating the mixture to the temperature not lower than a melting point of the diamine and not higher than a significant temperature of the polyester to cause reaction between the polyester and the diamine, wherein the significant temperature is a melting point of the porous polyester or a melt flow-start temperature of the polyester depending on crystal properties of the polyester.

The method may include further step of:
subjecting reaction product between the polyester and the diamine to melt-mixing for promoting further reaction between the polyester and the diamine.

The diamine may be modified polyorganosiloxane terminated at both ends with amino functional groups. The polymer compound comprises polyamide and/or polyester-amide copolymer.

According to the present invention, a polymer compound by reacting polyester polymerized from a dicarboxylic acid and a component of two OH functional groups and having intrinsic viscosity not less than 0. 2 dl/g with a diamine may be provided. The polymer compound comprises: particles of the polyester, the polyester having pores extending from a surface of the particles to inside thereof; and copolymer between the polyester and the diamine formed within the pores.

According to another aspect of the present invention, a structure comprising polyalylate-polyorganosiloxane (polymer compound) is provided. The polymer compound is formed by polyalylate and polyorganosiloxane with terminated both ends thereof by amino functional groups and is synthesized by an ester-amide exchange reaction of the polyalylate and the polyorganosiloxane, the polyorganosiloxane is present in the polymer compound between 1 and 50 weight%, wherein the polyalylate includes a repetition unit with the following formula (1); 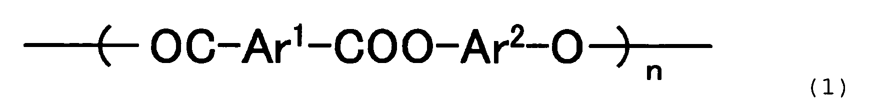 in which Ar¹ and Ar² may be identical or different groups and represent aromatic residues with two functionalities, and n represents an integer from 1 to 100, and wherein the polyorganosiloxane with terminated both ends thereof by amino functional groups is represented by the following formula (2); 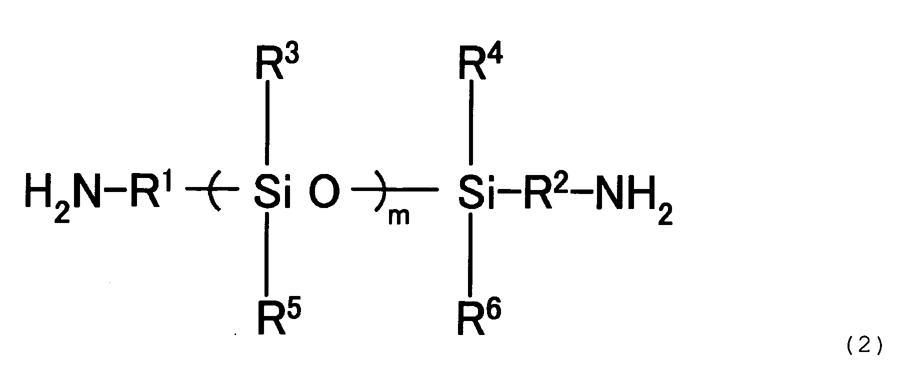 in which R¹ and R² may be identical or different groups and represent aliphatic groups or aromatic groups together having C₁-C₁₂ and R³, R⁹, R⁵, and R⁶may be identical ordifferent aliphatic groups or aromatic groups with one functionality, and m represents an integer equal to or larger than one.

According to the present invention, the structure may comprise an epoxy compounds from 1 to 200 weight parts to the polymer compound of 100 weight parts. The structure may be selected from the groups consisting of a metal foil laminated with the polymer compound, a prepreg comprising at least one reinforcing material and the polymer compound, a flexible print circuit and a print circuit board.

### Brief Explanation of Drawings

Fig. 1 shows an electronic microscope photograph of U-100 (D).
Fig. 2 shows an electronic microscope photograph of crushed particle of U-100.
Fig. 3 shows an electronic microscope photograph of porous GS300.
Fig. 4 shows an electronic microscope photograph of crushed particle of GS300.

Hereafter, the present invention will be described in detail.

### Best Mode of Invention

### Part I: Production of Polymer Compound

First, porous polyester used as a raw material in the present invention is defined as polyester having many pores extending from the surface of the polymer particle to the inside thereof. Sizes of the pores may generally have an average size with not more than 500 micro-meters, and more preferably with not more than 200 micro-meters, further preferably with not more than 100 micro-meters. In addition, the sizes of the porous polyester particle may be not more than 5 mili-meters, more preferably not more than 3 mili-meters. Furthermore, surface areas of the porous polyester particles may be equal to 0.01 m²/g or more, more preferably be equal to 0.05 m²/g or more, and most preferably be equal to 0.1m²/g or more, when the surface area is measured by a BET method. Generally, the porous polyesterparticlesmaybeproducedbythesolventprecipitation method in which the solution of polyester prepared with the polyester and organic solvent or inorganic solvent is introduced into poor solvent or non-solvent for the polyester under forced stirring conditions to cause precipitation of the porous polyester particles, or the extruder method in which the solution of the polyester is heated or heated under an reduced pressure condition in an extruder to evaporate the solvent included in the polyester, or the spray-dry method in which the solvent is evaporated from the sprayed polymer solution, or by any method known in the art.

Next, the polyester of the present invention may generally include the polyester produced by poly-condensation reactions between dicarboxylic acid selected from organic dicarboxylic acids or the derivatives thereof and dialcoholic components referred generally as "diols" or diphenols. The organic dicarboxylic acids or the derivatives thereof may include aromatic dicarboxylic acids and the derivatives thereof such as, for example, telephthalic acid, isophthalic acid, dimethyl telephthalate, telephthalicdichlorate, diphenyldicarboxylic acid, naphthalene dicarboxylic acid; and aliphatic dicarboxylic acids and the derivatives thereof such as, for example, oxalic acid, succinic acid, sebacic acid, maleic acid, fumalic acid. Diols may include, alkylene glycol such as, for example, ethylene glycol, propylene glycol, butan-1,3-diol, butan-1,4-diol, hexamethylene glycol, octamethylene glycol and cycrohexane diol. Diphenol compounds may include such as for example, resorcinol, hydroquinone, 4,4'-biphenol, 2,2'-biphenol, bis (4-hydroxyphenyl) methane, bis (2-hydroxyphenyl) methane, bis (4-hydroxyphenyl) ether, bis (4-hydroxyphenyl) sulfone, bis (4-hydroxyphenyl) sulfoxide, bis (4-hydroxyphenyl) ketone, bis (4-hydroxyphenyl) diphenyl methane, 4, 4'-(m-phenylene diisopropylidene) bisphenol, 4, 4'-(p-phenylene diisopropylidene) bisphenol, 4,4'-(p-phenylene diisopropylidene) bis (2,6-xylenol), bis (3,5-dimethyl-4-hydroxyphenyl)methane, bis (3-methyl-4-hydroxyphenyl)methane, bis (3,5-dimethyl-4-hydroxyphenyl)ether, bis (3,5-dimethyl-4-hydroxyphenyl)sulfone, bis (3,5-dimethyl-4-hydroxyphenyl sulfide, 1,1-bis (4-hydroxyphenyl) ethane, 1,1-bis (3,5-dimethyl-4-hydroxyphenyl) ethane, 1,1-bis (4-hydroxyphenyl) cyclohexane, 1,1-bis (4-hydroxyphenyl)-3,3,5-trimethyl-cyclohexane, 1,1-bis (4-hydroxyphenyl)-1-phenylethane, 2,2-bis (4-hydroxyphenyl) propane, 4,4'-(1-methyl pentylidene) bisphenol, 2,2-bis (4-hydroxyphenyl) butane, 2,2-bis (3,5-dimethyl-4-hydroxyphenyl) propane, 2,2-bis (3-methyl-4-hydroxyphenyl) propane, 2,2-bis (3-chloro-4-hydroxyphenyl) propane, 2,2-bis (3,5-dichloro-4-hydroxyphenyl) propane, 2,2-bis (3-bromo-4-hydroxyphenyl)propane, 2,2-bis (3,5-dibromo-4-hydroxyphenyl)propane, 1,1,1,3,3,3-hexafluoro-2,2-bis (4-hydroxyphenyl) propane, 4,4'- dihydroxybiphenyl, 3,3',5,5'- tetramethyl-4,4'-dihydroxybiphenyl, 4,4'-dihydroxy benzophenone; and terpene diphenol compounds such as, for example, 1,4- di(4-hydroxyphenyl)-p-menthane, 1,4-di(3-methyl-4-hydroxyphenyl)-p-menthane, 1,4-di(3,5-dimethyl-4-hydroxyphenyl)-p-menthane. Here, the above dicarboxylic acids, dialcohols, and diphenols may be used alone or any mixture including two or more without any limitation.

In the present invention, the polymers preferably used may include polyalylate and polyethylene telephthalate produced by mainly telephthalic acid and/or isophthalic acid as dicarboxylic acids and 2,2-bis (4-hydroxyphenyl)propane (bisphenol A) as the diphenol and ethylene glycol as the dialcoholic component. In addition, polyester may be used as an admixture including two kinds of polyester. Other organic polymer or inorganic compounds may be mixed into the polyester resin of the present method without any limitation. Intrinsic viscosity of the polyester used for the raw material may be not less than 0.2 dl/g, and more preferably be not less than 0.3 dl /g in the solvent of hexafluoro-isopropanol at 30 Celsius degrees. Furthermore, moisture ratio of the polyester used in the present invention may be not more than 1000 ppm, more preferably be not more than 500 ppm, and most preferably be not more than 100 ppm.

The diamines to which the polyester reacts may include aliphatic diamines such as , for example, ethylene diamine, trimethylene diamine, tetramethylene diamine, pentamethylene diamine, hexamethylene diamine, octamethylene diamine, dodecamethylene diamine, trimethylene-1,6-hexamethylene diamine and the like; aromatic diamine compounds such as, for example, p-phenylenediamine, m-phenylenediamine, o-phenylenediamine, 2,3-tolylenediamine, 2,4-tolylenediamine, 2,5-tolylenediamine, 2,6-tolylenediamine, 3,4-tolylenediamine, 3,5-tolylenediamine, p-xylylenediamine, m-xylylenediamine, o-xylylenediamine, 4,4'-diamino-diphenylmethane, 4,4'-diamino-biphenyl, 3,3'-dimethyl-4,4'-diamino-biphenyl, 3,3'-dichloro-4,4'-diamino-biphenyl, 4,4'-diamino-diphenylether, 4,4'-diamino-diphenylpropane, 4,4'-diamino-diphenylsulfone, 4,4'-diamino-diphenylsulfide, 4,4'-diamino-benzanilide, 3,3'-dimethyl-4,4'-diamino-diphenylmethane, 3,3'-diethyl-4,4'-diamino-diphenylmethane, 4,4'-diamino-anthraquinone, 3,3'-dimethoxy-benzidine, alpha,alpha'-bis (4-aminophenyl)-p-diisopropylbenzene, 1,5-diamino-naphthalene, 2,6-diamino-naphthalene and the like; aliphatic diamine compounds such as, for example, 1,3-diamino-cyclohexane, 1,4-diamino-cyclohexane, 1,3-bis (amino-methyl) cyclohexane, isophorone-diamine, piperazine, 2,5-dimethyl-piperazine, bis (4-amino-cyclohexyl)methane, bis (4-amino-cyclohexyl) propane, 4,4'-diamino-3,3'-dimethyl-dicyclohexyl-methane, alpha,alpha'-bis (4-amino-cyclohexyl)-p-diisopropyl-benzene, alpha, alpha' -bis (4-amino-cyclohexyl)-m-diisopropyl-benzene, and menthane-diamine and the like, and diamino-polymers such as, for example, diamine-polyorganosiloxane, diamino-polyether and the like. In the above diamins, diamino-polyorganosiloxane is especially preferred. These diamines may be used alone or mixture of two or more kinds of the above without any limitation. The above diamines may be preferably have moisture ratio equal to or less than 1000 ppm, more preferably equal to or less than 500 ppm, andmost preferably equal to or less than 100 ppm.

According to the present invention, polyamide may be derived when the diamime substitute all of the ester functional groups in the polyester by the ester-amide substitution, and polyester-amide copolymer may be derived when the diamimes substitute some parts of the ester functional groups in the polyester.

The amount of the diamines used in the present invention may range from 0.001 to 1.5 mol per 1 mol of the repetition units of the polyester resin, more preferably may range from 0.005 to 1.3 mol per 1 mol of the repetition units of the polyester resin, and most preferably may range from 0.01 to 1.2 mol per 1 Mol of the repetition units of the polyester resin. When the amounts of the diamines may be less than 0.001 mol per 1 mol of the repetition units of the polyester resin, excellent polyester-amide copolymer could not be obtained. When the amounts of the diamines exceed 1.5 mol per 1 mol of the repetition units of the polyester, molecular weights of the produced polyamide or polyester-amide copolymer become low, or alternatively, the produced polyamide or polyester-amide copolymer tend to form insoluble and non-melt gel during melt-mixing operation

According to the present invention, the objected polyamide or polyester-amide copolymer may be obtained by the procedures described as follows; filling specified amounts of the porous polyester and the diamine as the raw materials in a reaction vessel having heating, pressurizing and/or pressure reducing mechanisms together with a stirring mechanism; next heating the reaction vessel to a melting point of the used diamine while maintaining temperature thereof equal to or less than a significant temperature of the porous polyester. The significant temperature corresponds to the melting point of the porous polyester if the polyester has a crystal property; the significant temperature corresponds to the flow-start temperature if the polyester has a non-crystal property. The process next goes to the step of stirring and heating the mixture while substituting inside of the vessel with circumstance of inert gas atmosphere such as nitrogen gas at either pressurized or reduced pressure conditions under an air tight condition for causing the polyester resin and the diamine compounds to react.

Now, the temperature for reacting the porous polyester and the diamine may be adopted to be the temperature not lower than the melting point of the diamine compound and not higher than the significant temperature of the porous polyester; such temperature ranges generally between 100 Celsius degrees and 350 Celsius degrees. On the other hand, reaction time may range normally from 0.5 hour to 50 hours, and may more preferably range from 1 hour to 40 hours, and may most preferably range from 2 hours to 30 hours, though the reaction time depends on shape of the porous polyester (pore size, surface area, particle size) and viscosity of the diamine.

The reaction vessel used for practicing the reaction of the present invention may include such as, for example, a reaction vessel made of metal and formed as any type such as, for example, vertical, lateral, rotation types or a mixing-drying machine used for powder material so far as the vessel has an opening for supplying raw materials and an opening for recovering the reaction product and is able to heat uniformly the inside thereof under pressurized or reduced pressure conditions.

As described above, according to the method of the present invention, the problem, in which the reaction products aggregate during the reaction process to form chunks and subsequently to form the lump in the reaction vessel even when large amounts of diamine especially including high viscosity diamino-polymers are reacted, can not occur in the solvent less condition.

The intrinsic viscosity of thus obtained polyamide or polyester-amide copolymer may range from about 0.3 dl/g to about 1.5 dl /g. Further higher molecular weights may be attained by subj ecting the reaction product to melt-mixing process after filling the reaction product in a proper melt-mixing machine so as to further promote the reaction between the polyester and the diamine in the melt-mixing machine.

The temperature adopted when promoting the reaction between the polyester and the diamine by the melt-mixing is generally set from 150 Celsius degrees to 400 Celsius degrees, andmore preferably is set from 200 Celsius degrees to 350 Celsius degrees. If the reaction temperature is lower than 150 Celsius degree, the reaction product can not sufficiently be melted, and contradictory to this, if the temperature is higher than 400 Celsius degree, thermal decomposition of the produced polyamide or polyester-amide copolymer as the final product becomes severe so that expected reaction products can not be obtained.

Further to the above, time duration for the melt-mixing may be usually set from 0.1 min. to 30 min. If the mixing time is shorter than 0.1 min., the reaction does not sufficiently complete and the mixing time longer than 30 min. may result in degradation of the resin by decomposition or in gel formation of the obtained polyamide resin or polyester-amide copolymer. It is desired to fill the inside of the mixing machine with inert gas such as nitrogen gas during the mixing operation.

The melt-mixing machine used to perform the mixing may be adopted among any machine known in the art as far as it can mix high viscosity resin under heated conditions. Such mixing machines may include, for example, a roller machine, an extruder, and a kneader. Among the above machines, an extruder equipping one axis or two axes together with ventilation facilities or a kneader may be preferably adopted, because mixing process under high temperature is easy and removal of byproducts and/or recovery of the reaction products are easy. The intrinsic viscosity of thus obtained becomes typically from about 0.5 dl/g to about 2.0 dl /g.

The polyamide and polyester-amide copolymer as the final products may be compounded with various compounding materials selected from the group consisting of known any thermal stabilization agent, any light stabilization agent, any coloring agent, any lubricant agent, any reinforce material, any filler and the like as alone or admixture thereof and then are molded to a desired mold product by using various methods selected from the group consisting of a compression mold method, an inject ion molding method, and/or an extrusion molding met hod. Alternatively, these polyamide or polyester-amide copolymer may be used as various coating compositions or interlayer insulator or films etc. by solving thereof in suitable solvents as varnishes.

### Part II: Structure including Polymer Compound

The polyalylate-polyorganosiloxane of the present invention used to form the structure according to the present invention may be block or random copolymer produced by polyalylate and diamino-polyorganosiloxane which is terminated the both ends thereof with amino functional groups through an ester-amide exchange reaction. Here, polyalylate may be produced by poly-condensation reaction of aromatic dicarboxylic acids or the esters thereof with lower alkyl groups, aryl groups, carbonates, and/or acid chlorides and two functional phenols.

Such aromatic dicarboxylic acids may include, as described above, for example, telephthalic acid, isophthalic acid, diphenyl-m,m'-dicarboxylic acid, diphenyl-p,p'-dicarboxylic acid, diphenyl methane-m,m'-dicarboxylic acid, diphenyl methane-p,p'-dicarboxylic acid, benzophenone-4,4'-dicarboxylic acid, 2,6-naphthalene dicarboxylic acid and the like. These compounds may be used alone or any mixture including two or more compounds. In addition, aliphatic dicarboxylic acids such as adipic acid, sebacic acid, and the lower alkyl esters thereof, aryl esters, carbonate esters, and acid chlorides may be mixed therein as far as property of the copolymer is not degraded. In the case where the aliphatic dicarboxylic acids or the esters thereof are used, such aliphatic dicarboxylic acids or the esters thereof may be used in the amounts of 30 wt% of the total dicarboxylic acid units at most.

Two functional phenols used for producing the polyalylate may be selected from phenolic compounds described before. Here, the two functional phenols may be used alone or any mixture among the above described phenolic compounds. Preferred polyalylate may include the polymer polymerized by poly-condensation reaction using an admixture of telephthalic acid and isophthalic acid as the aromatic dicarboxylic acids, and two functional phenols such as , for example, 2,2-bis(4-hydroxyphenyl)propane, 2,2-bis(3,5-dimethyl-4-hydroxyphenyl)propane, 2,2-bis(3-methyl-4-hydroxyphenyl)propane, 2,2-bis(3-chloro-4-hydroxyphenyl)propane, 2,2-bis(3,5-dichloro-4-hydroxyphenyl)propane.

Next, the polyorganosiloxane compound terminated both ends with amino functional groups provided to the ester-amide exchange reaction is represented by the following general formula (3): 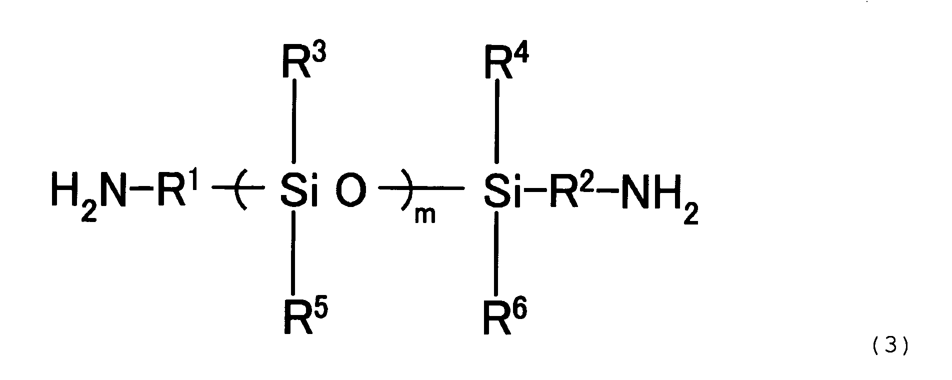 (wherein in formula (3), R¹ and R² may be identical or different groups and represent aliphatic groups or aromatic groups together having C₁-C₁₂ and R³, R⁴, R⁵, and R⁶ may be identical or different aliphatic groups or aromatic groups with one functionality, and m represents an integer equal to or larger than one. Here, two functional aliphatic groups of R¹ and R² may include alkylene groups etc. and two functional aromatic groups may include p-phenylene, m-phenylene, diphenylene, naphthylene groups etc. R³, R⁴, R⁵, and R⁶ may be selected from the groups consisting of methyl, ethyl, or phenyl groups. There is no particular limitation on molecular weight of the polyorganosiloxane; however, m with between 1 and 100 is preferred and m with between 2 and 50 is more preferred. Such polyorganosiloxanes commercially available include X-22-1660B-3, X-22-161A, X-22-161B, X-22-161AB, KF-8012 from SHIN-ETSU CHEMICAL. Co., Japan.

Preparation of the polyalylate-polyorganosiloxane is accomplished by the ester-amide exchange reaction between the above polyalylate and the polyorganosiloxane terminated by amino functional groups at both ends thereof. The ester-amide exchange reaction may be conducted by the steps comprising packing porous polyalylate and polyorganosiloxane terminated at both ends with amino functional groups in a reaction vessel equipping with an adequate inside stirring device at weight ratio of polyaylate to polyorganosiloxane between 99: 1 to 50: 50 under solvent less condition and removing outside the reaction system two functional phenol as the byproduct. The reaction temperature therefor is preferred to be 100-300 Celsius degrees and the reaction time is preferred to be 1-50 hours. In addition, the polyalylate and polyorganosiloxane terminated at both ends with amino functional groups are preferably dried to the moisture ratio less than 500 ppm, more preferably less than 100 ppm prior to the reaction. The ester-amide exchange reaction can be effectively propelled by only using porous polyalylate with polyorganosiloxane.

Here, the powder has an average particle size not more than 1000 micro-meters, and more preferably has an average particle size not more than 500 micro-meters. Also, the term "porous" means presence of pores extending from the surface of the particle to inside thereof and the pore size may be not more than 500 micro-meters and more preferably be not more than 100 micro-meters.

The polyalylate-polyorganosiloxane of the present invention preferable includes a polyorganosiloxane structure from 1 to 50 wt%, more preferably from 2 to 40 wt%. In this range, Tg, a dielectric constant, a fire-retardant property, mechanical strength, water repellent (or moisture absorbency) are suitably balanced for the usage of the insulation material for a print circuit board. Molecular weights of the polyalylate-polyorganosiloxane of the present invention may range so as to providing intrinsic viscosity to be not less than 0.3 dl/g, more preferably be not less than 0.5 dl /g when measured at 30 Celsius degree in methylene chloride. When the intrinsic viscosity becomes to the level less than 0.3 dl /g, the obtained polyalylate-polyorganosiloxane has poor mechanical strength and becomes improper to the insulation material for the print circuit board.

Next, it is preferred to formulate an epoxy resin to the polyalylate-polyorganosiloxane of the present invention because adhesion and heat resistance of the polymer compound may further be improved. Examples of the epoxy resinmay include two functional epoxy resins derived from two functional phenols such as bisphenol A, bisphenol F, bisphenol S, fluorene-bisphenol, 4,4'-biphenol, 2,2'-biphenol, hydroquinone, and resorcin; multi-functional epoxy resins derived by poly-condensation of hydroxybenzaldehyde and phenols; novolak type epoxy resin derived from novolak type compounds such as phenol novolak or cresol novolak and the like. These epoxy resins may be used alone or may be used in any mixture thereof including two or more kinds.

The amounts of formulation of the epoxy resin may be selected to be from 1 to 200 weight parts, and more preferably from 2 to 100 weight parts to the polyalylate-polyorganosiloxane of 100 weight parts. When the amounts of formulation become less than 1 weight part, the effect of the formulation of the epoxy compounds is not significant. When the amounts of formulation of the epoxy compounds become more than 200 weight parts, the effect of formulation goes to saturation and problems in recycle-ability and the fire-retardant property may occur.

In the present invention, when curing of the epoxy resin is requested, epoxy curing agents may be formulated in the polymer compound of the present invention. Kinds of such epoxy curing agents may include such as, for example, phenol type curing agent such as phenol novolak, cresol novolak, phenol modified polybutadiene; amine type curing agents such as dicyan-diamide, diamino-diphenyl-methane, diamino-diphenylsulfone, diethylene-triamine etc.; and acid anhydrates such as pyromellitic acid anhydrate, trimellitic acid anhydrate, and benzophenone-tetracarboxylic acid dianhydrate and the like.

In the present invention, additives may be added to the polymer compound. Such additives may be selected from the group consisting of various thermal stabilizers for stabilizing thermal property of the resin, various surface active agents or silane coupling agents for improving wetting property, various fire-retardant agents for improving the fire-retardant property. Also, depending on particular requirements, inorganic fillers, or various polymers such as polyimide, polyphenylene ether, polyetherimide, polysulfone, polyester, polycarbonate, etc. may be included within the scope of the present invention.

The polymer compound of the present invention has in its properties an adequate mechanical property, high Tg, a low dielectric constant,afire-retardantproperty withthe halogen free, water absorbency, an adhesion property (to metal foils, glass fibers), high chemical resistance (to acids, alkaline materials) and the like. The polymer compound of the present invention has a thermo-plastic property so that troublesome managements of pot-life may be omitted and may be easily coated on various substrate metal foils such as a cupper foil or an aluminum foil etc., a glass fiber mat, a glass fiber paper, an aramide fiber paper etc. after dissolving the polymer compound to a proper solvent. It may be possible to form a film by a T-die method without any solvent (i. e. , melt-extrusion method) and therefore, the polymer compound of the present invention is a material which is greatly appreciated in the point of the earth environment together with the recycle-ability thereof. From the above properties, the polymer compound of the present invention may be suitably applied to various resin coated metal foils, prepregs, and insulators for various print circuit boards. In addition, since the polymer compound of the present invention has an excellent adhesion performance to glass and a silicone substrate etc., the polymer compound of the present invention can be used in wide technical fields when prepared as adhesives for semiconductor devices, interlayer insulation films, protection films, and coating compositions.

Hereunder, several examples of the present invention will be shown in order to further describe the present invention more concretely; however, the present invention should not be limited to the examples described below. Also it is understood by a person skilled in the art that various modifications, corrections, improvements may be made to the present invention based on ordinal knowledge of the art other than the concrete examples within scope of the present invention.

### Examples

### (Example 1)

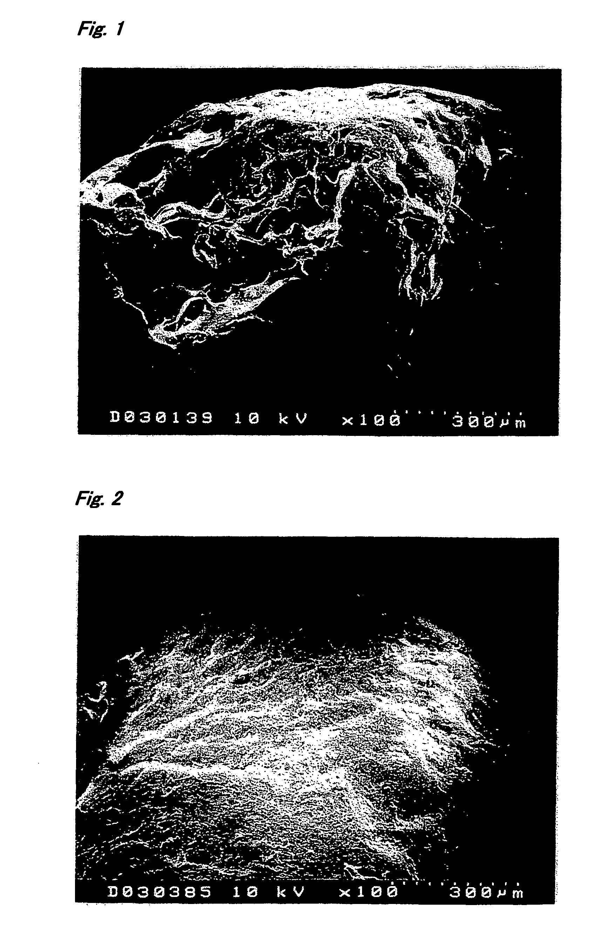

Commercially available porous polyalylate (U-100(D), YUNITIKA Co. Ltd., Japan, average particle size of 2 mili-meters) was used as polyester. Fig. 1 shows a photograph of U-100 (D) obtained by an electric microscope. As shown in Fig. 1, there are many pores extending from the particle surface to the inside thereof. Distribution of pore sizes was estimated to be from about 300 micro-meters to about 10 micro-meters. Surface area was measured to be 0.21 m²/g by the adsorption amounts of gas of N₂ (30%) /He (70%) mixture during 1 hour at 25 Celsius degree using AMS-8000 type apparatus (OHKURARIKEN Co. Ltd., Japan). Commercially available modified silicone oil KF-8012 (SHIN-ESTU CHEMICAL Co. Ltd., Japan, polyorganosiloxane terminated at both ends with amino functional groups, dimethyl type, amino equivalent value of 2300) was used as a diamine. U-100 (D) was dried to moisture ratio of 30 ppm in a heated-airflow-drier kept at constant temperature of 150 Celsius degree for 10 hours. KF-8012 was also dried to moisture ratio of 30 ppm by removing water through vacuum evaporation at 150 Celsius degree.

Next, the dried U-100 (D) of 6 kg and the dehydrated KF-8012 of 2 kg were set in a 10 L cone-shaped reaction vessel equipped with a ribbon type rotation wing and then the reaction mixture was stirred at 20 rpm, 200 Celsius degrees, reduced pressure of 5 mbar for 24 hours while removing reaction byproducts out of the reaction system. The reaction product did not make a lump and parts of the reaction products did not form chunks so that the reaction product kept excellent particle shapes as prior to the reaction. The reaction product of 1g was washed by stirring in acetone 500g (25 Celsius degree, 24 hours), then filtered, and dried (50 Celsius degrees, 24 hours). The reaction product showed weight loss of 5 weight% (wt%). Therefore, it was concluded that 80 wt% of KF-8012 was reacted with U-100 (D). Results of IR analysis showed strong absorption peaks at 1720 cm⁻¹ and 1000-1100 cm⁻¹, and hence the polymer compound between polyalylate and polyorganosiloxane was confirmed. The intrinsic viscosity thereof was 0.70 dl/g.

The reaction product was subjected to melt-mixing using a two axis extruder (Berstorff, screw diameter of 40 mm, L/D=40, 3 ventilation holes) at 300 Celsius degrees, rotation speed of 100 rpm, discharge amount 10 kg/hour under the ventilation to be reduced pressure of 10 torr and then was cooled by water to form pellets. The obtained pellets were crushed and washed by acetone followed by drying. The pellets showed weight loss of 1 wt%. Therefore, it was shown that 96 wt% of KF-8012 was reacted with U-100 (D) by the melt-mixing. Also, results of IR analysis of this sample were almost same with the sample prior to the melt-mixing. The intrinsic viscosity was 0.85 dl/g.

### (Comparable example 1)

Pellets shaped polyalylate (U-100, YUNITIKA Co. Ltd., Japan) were mechanically crushed and the powder passed through a mesh of 500 was used instead of the porous polyalylate U-100 (D) and an experiment similar to Example 1 was performed. The reaction product formed a stringy lump in the reaction vessel during the reaction process and it was hard to continue the reaction. Also it was also hard to take the reaction product out of the vessel. Fig. 2 shows a photograph of an electric microscope of the surface of U-100 particles which were formed bymechanical crushing. There were no pores extending to inside of the particle and the surface was flat. Surface area of the crushed particle was 0.005m²/g.

### (Example 2)

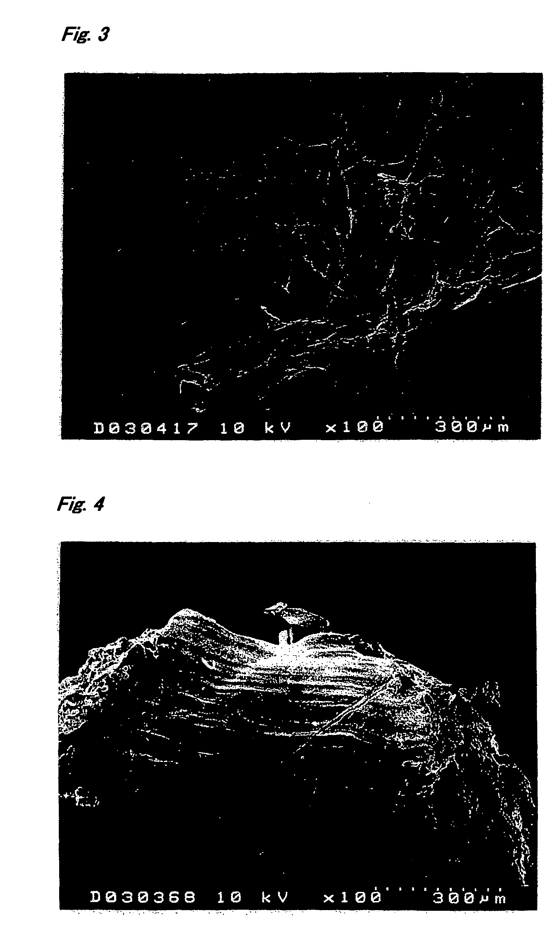

Commercially available polyethylene telephthalete (NOVAPEX GS300, MITSUBISHI CHEMICAL Co., Japan) of 50 g was dissolved into hexafluoro-isopropanol (WAKO JUNYAKU KOGYO CO., Ltd., Japan) at 30 Celsius degree to prepare solution of 15 wt%. The solution was poured intermittently into stirred ethanol/water mixture (1:1 weight ratio) to precipitate GS300 as porous particle. The precipitation was dried at 80 Celsius degrees, under 10 mbar for 10 hours and obtained porous GS300 particles. Fig. 3 shows an electro microscope photograph of the particle of GS300. As shown in Fig. 3, it is shown that there are many pores extending from its surface to inside thereof. The pore size was ranged from 100 to 30 micro-meters. Also, the surface area was 5.1 m²/g. These porous GS300 of 30g and KF-8012 of 10g used in the example 1 were set in a glass vessel and sufficiently mixed by stirring. Next, the glass vessel was set in a vacuum drier kept at 220 Celsius degree and reduced pressure inside thereof to 10 mbar to perform the reaction for 40 hours. After reaction was completed, the vessel was cooled to room temperature and reaction product was recovered from the vessel. The reaction product kept the shape prior to start of the reaction rather than forming lump. The reaction product was washed with acetone and dried as described in the example 1, weight loss of 3 wt% was observed. Therefore, it was determined that 88 wt% of KF-8012 was reacted with GS300. When the reaction product after washing with acetone was subjected to IR analysis, similar absorption spectrum with the sample of the example 1 was obtained. The intrinsic viscosity thereof was 0.76 dl/g.

### (Comparable example 2)

Pellets shaped GS300 were mechanically crushed and the powder passed through a mesh of 500 was used instead of the porous GS300 and an experiment similar to example 2 was performed. The reaction product formed a lump during the reaction process. Fig. 2 shows an electric micro scope photograph of the crushed GS300 particle. As was the comparative example 1, there were no pores extending to inside of the particle and the surface area was no more than a detection limit of the apparatus.

### (Example 3)

Commercially available porous polyalylate U-100 (D) (YUNITIKA, CO. Ltd., Japan, dicarboxylicacidcomponents; equal molar mixture of telephthalic acid and isophthalic acid, diphenol component; 2,2-bis(4-hydroxyphenyl)propane, glass transition temperature of 199 Celsius degree) and KF-8012 were used in this example by making thereof to the same moisture condition. ThedriedU-100 (D) of 6kgandthedehydratedKF-8012 of 2kg were set in a 10L cone-shaped reaction vessel equipped with a ribbon type rotation wing and then the reaction mixture was stirred at 20 rpm, 205 Celsius degrees, reduced pressure of 1 mbar for 20 hours while removing reaction byproducts from the reaction system. The polyalylate-polyorganosiloxane copolymer, U-100 (D) /KF-8012 (hereafter referred to copolymer A) of 7.9 kg was obtained. In order to examine reaction level of KF-8012, the copolymer A was mechanically crushed and the powder of 10g passed through a 100 mesh metal screen was added to acetone of 500g under stirring for 10 hours to remove non-reacted KF-8012. When solids were recovered and were filtered and dried, weight loss of 0.7 wt% was found. Also measurements of IR spectra and intrinsic viscosity were conducted and there was no difference in the IR spectra before and after the acetone washing and the intrinsic viscosity (hexafluoro-isopropanol, 30 Celsius degrees) was 0.70 dl/g before washing and was 0.73 dl /g after washing, respectively. The above results showed that about all amounts of KF-8012 were reacted with U-100 (D).

Next, the copolymer A was dissolved in methylene chloride to obtain its solution of 20 wt%. The solution was coated on an electrolysis cupper foil of 38 micro-meters thickness (NIKKO MATERIALS. Co., Japan, JTC-1.0 Oz) by a wire-bar coater and then methylene chloride was evaporated to form a resin layer of 20 micro-meters thickness on the cupper foil. Two obtained resin coated cupper foils were layered at the resin layers facing inside and were pressured and adhered at 3MPa, 220 Celsius degrees for 10 min. in order to measure peel strength. On the other hand, a polypropylene film was used instead of the cupper foil and was coated by the solution to obtain a film of 20 micro-meters thickness followed by drying and peeling apart from the polypropylene film. The film was heat-treated at 220 Celsius degree for 10 min. and Tg, a dielectric constant, a dielectric loss tangent value, water absorbency, and a fire-retardant property were measured. The results are listed in Table 1.

**Table 1**

| Items | Methods of measurements | Values |
|---|---|---|
| Peel strength | JIS C-6471 | 0.92 kN/m |
| Tg | JIS C-6481 (TMA) | 190°C |
| Dielectric Constant | JIS C-6471 | 3.0 |
| Dielectric Loss Tangent | JIS C-6471 | 0.003 |
| Water Absorbency | JIS C-6481 | 0.02% |
| Noncombustivity | UL-94 | V-0 |

### (Example 4)

Commercially available porous polyalylate PAR-4 (YUNITIKA Co. , Ltd. Japan, glass transition temperature of 240 Celsius degree) was used. PAR-4 was dried by the same manner in the example 3 to provide moisture ratio of 30 ppm. KF-8012 as polyorganosiloxane with terminated both ends by amino functional groups, which was the same with that used in the example 3, was used. The dried PAR-4 of 30g and the dehydrated KF-8012 of 10g were set and mixed in a glass vessel of 100 mili-liters and then were reacted for 20 hours at 230 Celsius degrees in a vacuum drier under the pressure of 1 mbar. The reaction product; PAR-4/KF-8012 of 39.5g with porous particle shaped and with slightly colored in brown was obtained. The reaction product was prepared as a solution, a resin coated cupper foil and a film and thereafter was examined according to the same manner as described in the example 1. The results are listed in Table 2.

**Table 2**

| Items | Methods of measurements | Values |
|---|---|---|
| Peel strength | JIS C-6471 | 0.90 kN/m |
| Tg | JIS C-6481 (TMA) | 236°C |
| Dielectric Constant | JIS C-6471 | 3.0 |
| Dielectric Loss Tangent | JIS C-6471 | 0.002 |
| Water Absorbency | JIS C-6481 | 0.01% |
| Noncombustivity | UL-94 | V-0 |

### (Example 5)

The copolymer A of 16g obtained in the example 3, EPICOAT 828 (Japan Epoxy Resin Co. Ltd., Japan, bisphenol A type epoxy resin) of 2g and EPICOAT 152 (Japan Epoxy Resin Co. Ltd. , Japan, phenol novolak type epoxy resin) of 2g were dissolved in methylene chloride of 80g to prepare the solution of 20 wt% (resin contents). A resin coated cupper foil and a film were formed and thereafter examined according to the same manner as described in the example 3. The results are listed in Table 3.

**Table 3**

| Items | Methods of measurements | Values |
|---|---|---|
| Peel strength | JIS C-6471 | 1.26 kN/m |
| Tg | JIS C-6481 (TMA) | 200°C |
| Dielectric Constant | JIS C-6471 | 3.2 |
| Dielectric Loss Tangent | JIS C-6471 | 0.003 |
| Water Absorbency | JIS C-6481 | 0.02% |
| Noncombustivity | UL-94 | V-0 |

### (Example 6)

The same experiment with example 3 was conducted while using commercially available modified silicone oil X-22-161A (SHIN-ETSU CHEMICAL Co. Ltd., Japan, amino equivalent value=840) as the polyorganosiloxane with both ends terminated with two amino functional groups. The results are listed in Table 4.

**Table 4**

| Items | Methods of measurements | Values |
|---|---|---|
| Peel strength | JIS C-6471 | 0.78 kN/m |
| Tg | JIS C-6481 (TMA) | 190°C |
| Dielectric Constant | JIS C-6471 | 3.2 |
| Dielectric Tangent | JIS C-6471 | 0.001 |
| Water Absorbency | JIS C-6481 | 0.02% |
| Noncombustivity | UL-94 | V-0 |

### (Example 7)

The polymer compound, U-100 (D)/KF-8012 (hereafter referred to copolymer B) was prepared by the same method with the example 3 while using the dehydrated KF-8012 of 4 kg. Using the copolymer B, the solution of 20 wt % was prepared according to the methods described in the example 3 and then a resin coated cupper foil and a film were formed and thereafter examined. The results are listed in Table 5.

**Table 5**

| Items | Methods of measurements | Values |
|---|---|---|
| Peel strength | JIS C-6471 | 0.85 kN/m |
| Tg | JIS C-6481 (TMA) | 180°C |
| Dielectric Constant | JIS C-6471 | 2.9 |
| Dielectric Loss Tangent | JIS C-6471 | 0.001 |
| Water Absorbency | JIS C-6481 | 0.01% |
| Noncombustivity | UL-94 | V-0 |

### (Example 8)

The solution prepared in example 5 was coated by a wire-bar coater on a glass-cloth (ASAHI SHUEBEL Co. Ltd., Japan, 2116) and then the solvent was evaporated and removed to form a prepreg with a solid content of 50 wt%. The prepreg was held between the electrolysis cupper foil and pressured at 190 Celsius degrees, 3 MPa for 10 min. to obtain a cupper clad laminate. Peel strength was examined and was found to be 1.35 kN/m.

### (Example 9)

Thermount N720#8 (aramide paper of Teijin DuPont Advanced Paper Co. Ltd., Japan) was used instead of the glass cloth for the experiment same with the example 8 and the peel strength thereof was found to be 1.30 kN/m.

### (Example 10)

A similar experiment with the example 1 was conducted substituting KF-8012 with commercially available modified silicone oil X-22-1660B-3 (SHIN-ETSU CHEMICAL Co., Ltd., Japan, polyorganosiloxane terminated both ends with two amino functional groups, methyl-phenyl type, amino equivalent value=2300). A reaction product did not form the lump which was formed by the parts thereof and then kept excellent particle shapes as is before the reaction. When the reaction products of 1g were washed by stirring in acetone of 500g (25 Celsius degrees, 24 hours), and then were filtered and dried (50 Celsius degrees), the weight loss of 4 wt% was observed. Therefore, X-22-1660B-3 of 84 wt% was reacted with U-100 (D). The intrinsic viscosity of the washed product was found to be 0.71 dl/g. The reaction product was subjected to the melt-mixing and tested in the same condition described in the example 1. The weight loss after the acetone washing was found to be 1 wt% and the intrinsic viscosity was found to be 0.87 dl /g. This result was almost same with those of the example 1.

### Advantage of Invention

As described above, a method for producing polyamide and polyester-amide copolymer according to the present invention , which uses the porous polyester, makes it possible to produce polyamide and polyester-amide copolymer without forming the lump or the chunks of the reaction product even when high viscosity diamino-polymers are used as diamines.

The polyalylate-polyorganosiloxane of the present invention showed excellent adhesion strength (peel strength), high heat resistances (Tg), low dielectric constants, low water absorbency, and a fire-retardant property. In addition, the polyalylate-polyorganosiloxane of the present invention has an excellent flexibility so that the polyalylate-polyorganosiloxane is the most suitable to the insulator material for a flexible print circuit board as well as a prepreg and insulation materials.

## Claims

1. A method for producing polymer compound by reacting polyester polymerized from a dicarboxylic acid and a component of two OH functional groups and having intrinsic viscosity not less than 0.2 dl/g, with a diamine, said method comprising the steps of:
providing particles of said polyester, said polyester having pores extending from a surface of said particle to inside thereof;
mixing said porous polyester with said diamine; and
heating said mixture to the temperature not lower than a melting point of said diamine and not higher than a significant temperature of said polyester to cause reaction between said polyester and said diamine, wherein said significant temperature is a melting point of said porous polyester or a flow-start temperature of said polyester depending on crystal properties of said polyester.

2. The method according to claim 1, wherein said method further comprising the step of:
subjecting reaction product between said polyester and said diamine to melt-mixing for promoting further reaction between said polyester and said diamine.

3. The method according to claim 1, wherein said diamine is polyorganosiloxane terminated at both ends with amino functional groups.

4. The method according to claim 1, wherein said polymer compound is polyamide and/or polyester-amide copolymer.

5. A polymer compound by reacting polyester polymerized from a dicarboxylic acid and a component of two OH functional groups and having intrinsic viscosity not less than 0.2 dl/g with a diamine, said polymer compound comprising:
particles of said polyester, said polyester having pores extending from a surface of said particles to inside thereof; and
copolymer between said polyester and said diamine formed within said pores.

6. A structure comprising polymer compound, said polymer compound being formed by polyalylate and a polyorganosiloxane with terminated both ends thereof by amino functional groups and being synthesized by an ester-amide exchange reaction of said polyalylate and said polyorganosiloxane, said polyorganosiloxane being present in said polymer compound between 1 and 50 weight%,
wherein said polyalylate includes a repetition unit with the following formula (4); 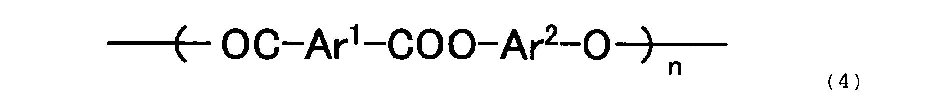 in which Ar¹ and Ar² may be identical or different groups and represent aromatic residues with two functionalities, and n represents an integer from 1 to 100, and
whereinsaidpolyorganosiloxanewithterminatedbothends thereof by amino functional groups is represented by the following formula (5); 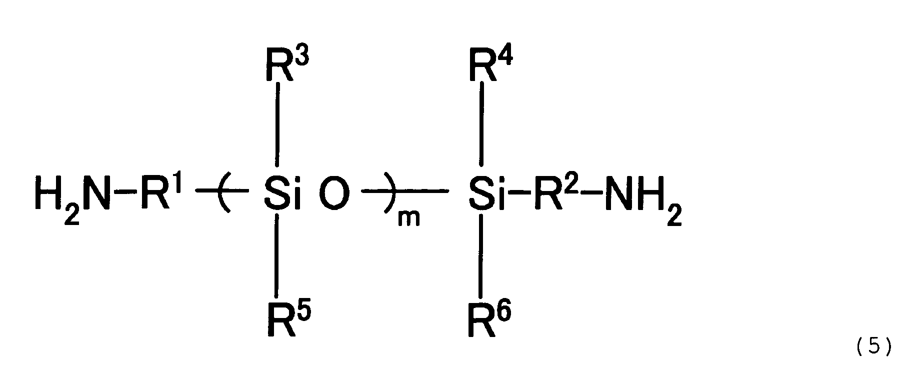 in which R¹ and R² may be identical or different groups and represent aliphatic groups or aromatic groups together having C₁-C₁₂, and R³, R⁴, R⁵, and R⁶ may be identical or different aliphatic groups or aromatic groups with one functionality, and m represents an integer equal to or larger than one.

7. The structure according to claim 6, wherein said structure comprises an epoxy compound from 1 to 200 weight parts to said polymer compound of 100 weight parts.

8. The structure according to claim 6, wherein said structure is selected from the groups consisting of a metal foil laminated with said polymer compound, a prepreg comprising at least one reinforcing material and said polymer compound, a flexible print circuit or a print circuit board.

9. The structure according to 6, wherein said polyalylate polymer has a particle form, and said particle has pores extending from a surface to inside thereof.
